# FASCICULE DE BREVET EUROPEEN

(11) **EP 3 346 030 B1**
(45) Date de publication et mention de la délivrance du brevet: **06.03.2019**
(21) Numéro de dépôt: 18150263.4
(22) Date de dépôt: 04.01.2018
(51) Int. Cl.: C30B 11/00, C30B 29/52, B22D 27/04

(54) **INSTALLATION POUR LA FABRICATION D'UNE PIECE PAR MISE EN OEUVRE D'UN PROCEDE BRIDGMAN**
ANLAGE FÜR DIE HERSTELLUNG EINES TEILS DURCH UMSETZUNG EINES BRIDGMAN-VERFAHRENS
FACILITY FOR MANUFACTURING A WORKPIECE BY PERFORMING A BRIDGMAN METHOD

(30) Priorité: 09.01.2017 FR 1750167
(43) Date de publication de la demande: 11.07.2018
(73) Titulaire: SAFRAN, 75015 Paris (FR); Safran Aircraft Engines, 75015 Paris (FR)
(72) Inventeur: GRANGE, David, 77550 MOISSY-CRAMAYEL (FR); MARTIN, Gilles, 77550 MOISSY-CRAMAYEL (FR)
(74) Mandataire: Cabinet Beau de Loménie

(56) Documents cités:
- EP-A2- 0 278 762
- GB-A- 2 404 353
- JP-A- 2002 144 019

## Description

### Arrière-plan de l'invention

L'invention concerne une installation pour la mise en oeuvre d'un procédé Bridgman ainsi qu'un procédé de fabrication d'une pièce mettant en oeuvre une telle installation.

Le procédé Bridgman peut être utilisé pour réaliser la solidification dirigée d'une pièce monocristalline. Cette technique permet de faire progresser le front de solidification dans une direction, d'un bout à l'autre de la pièce. Le four mis en oeuvre dans ce procédé comprend une zone chaude, dont la température est supérieure à la température de fusion du matériau destiné à former la pièce, ainsi qu'une zone froide régulée à une température permettant la solidification du matériau en fusion. La température de la zone chaude peut être maintenue par rayonnement par des suscepteurs chauffés par induction. Un écran thermique peut être présent à la frontière entre les zones froide et chaude. Entre ces deux zones règne un fort gradient de température.

Pour solidifier une pièce de manière dirigée, le matériau est introduit à l'état fondu dans un moule présent dans la partie chaude du four. Le moule ainsi rempli par le matériau en fusion est progressivement déplacé en direction de la zone froide. Le fort gradient de température permet d'obtenir un front de solidification localisé au niveau de la frontière entre la zone chaude et la zone froide.

Il est toutefois souhaitable d'améliorer les propriétés et la qualité des pièces obtenues par mise en oeuvre d'un procédé Bridgman.

L'invention vise à répondre au besoin précité.

### Objet et résumé de l'invention

A cet effet, l'invention propose, selon un premier aspect, une installation pour la fabrication d'une pièce par mise en oeuvre d'un procédé Bridgman, ladite installation comprenant :
- au moins un moule destiné à recevoir un matériau en fusion, le moule étant présent dans une zone de chauffage située à l'intérieur d'une enceinte,
- une zone de refroidissement située à l'intérieur de l'enceinte et séparée de la zone de chauffage par un premier écran thermique, le premier écran thermique étant fixe par rapport à l'enceinte et étant situé d'un premier côté du moule, la zone de chauffage étant superposée à la zone de refroidissement le long d'un axe de l'enceinte,
- un premier système de déplacement configuré pour déplacer le moule dans l'enceinte depuis la zone de chauffage vers la zone de refroidissement le long de l'axe de l'enceinte,
- un deuxième écran thermique mobile par rapport au moule distinct du premier écran thermique et situé d'un deuxième côté du moule opposé au premier côté, et
- un deuxième système de déplacement, distinct du premier système de déplacement, configuré pour déplacer le deuxième écran thermique dans l'enceinte le long de l'axe de l'enceinte.
- un écran thermique additionnel mobile (310) par rapport au moule et distinct des premier et deuxième écrans thermiques, l'écran thermique additionnel étant situé du deuxième côté du moule et étant superposé au deuxième écran thermique le long de l'axe de l'enceinte, la largeur (L2) de l'écran thermique additionnel étant inférieure à la largeur (LI) du deuxième écran thermique, et - un troisième système de déplacement (290), distinct des premier et deuxième systèmes de déplacement, configuré pour déplacer l'écran thermique additionnel dans l'enceinte le long de l'axe de l'enceinte indépendamment du deuxième écran thermique.

Des études menées par les inventeurs ont permis de constater que les propriétés de la pièce à obtenir sont dépendantes de l'aspect du gradient local de température au niveau du front de solidification et que les techniques Bridgman de l'art antérieur ne permettent pas d'obtenir un gradient de température optimal durant toute la solidification dirigée. Plus précisément, les inventeurs ont constaté qu'il est souhaitable, afin d'améliorer la qualité de la pièce obtenue par solidification dirigée, que ce gradient thermique ait une composante minimale dans la direction perpendiculaire à la direction de solidification. En d'autres termes, il est souhaitable de tendre au maximum vers un gradient de température parfaitement stabilisé, c'est-à-dire uniquement dirigé le long de la direction de solidification. Le fait d'utiliser un ou plusieurs écrans thermiques fixes par rapport au moule stabilise le gradient de température seulement à certains moments de la solidification mais pas à d'autres.

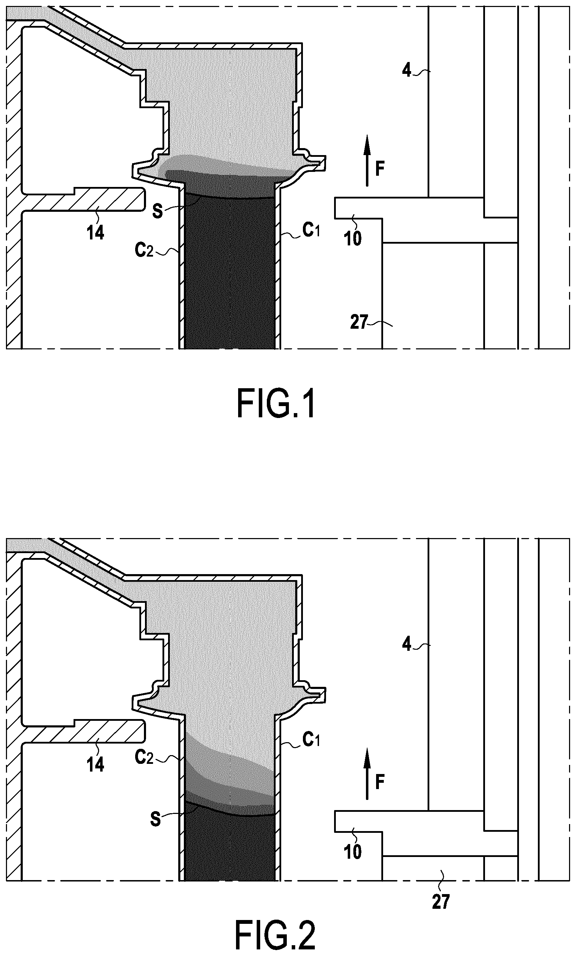

Ce constat est illustré par les figures 1 et 2 qui reproduisent, de manière schématique, des résultats de simulations numériques montrant l'aspect des courbes isothermes au niveau du front de solidification S pour une avancée verticale de ce dernier du bas vers le haut (flèche F) dans le cadre d'un procédé Bridgman avec écran thermique fixe par rapport au moule. L'installation illustrée aux figures 1 et 2 comprend un écran thermique 10 fixe par rapport à l'enceinte séparant la zone chaude (zone supérieure) de la zone froide (zone inférieure). Cette installation comprend en outre au moins un écran thermique supplémentaire 14 relié au moule et situé du côté opposé à l'écran 10. L'écran thermique 14 est donc fixe par rapport au moule. La figure 1 montre que l'écran thermique 14 stabilise le gradient de température lorsque le front de solidification S est au niveau de l'écran 14. Dans ce cas les courbes isothermes sont sensiblement horizontales et le gradient thermique est donc sensiblement dirigé le long de la direction F. En revanche à un instant antérieur, ces courbes isothermes présentaient une inclinaison notable et donc un gradient thermique horizontal significatif (figure 2). Dans ce dernier cas, on s'éloigne de l'aspect idéal pour le gradient thermique. L'écran thermique 14 engendre en effet une zone froide en dessous de lui qui déstabilise le gradient thermique lorsque le front de solidification S est en-dessous de l'écran 14. Les inventeurs ont donc constaté que la mise en oeuvre de l'écran thermique 14, fixe par rapport au moule, ne permet pas de stabiliser le gradient de température à tout instant de la solidification. En particulier, les inventeurs ont constaté que le côté du moule C₂ opposé à l'écran thermique 10 séparant la zone chaude de la zone froide présentait un refroidissement excessif à certains moments de la solidification par rapport au côté du moule C₁ situé du côté de cet écran 10 (figure 2). Une telle déstabilisation du gradient thermique peut conduire à la génération de défauts dans la pièce obtenue après solidification.

L'invention propose une installation permettant d'améliorer la stabilité du gradient thermique durant la solidification dirigée. Les premier et deuxième écrans thermiques sont situés de part et d'autre de chaque moule. La mise en oeuvre du deuxième écran thermique et du deuxième système de déplacement permet avantageusement de disposer d'un écran thermique, mobile par rapport au moule, permettant de suivre le front de solidification durant la solidification dirigée. Le fait de pouvoir modifier la position du deuxième écran thermique durant la solidification dirigée de sorte à le positionner en regard du front de solidification permet de stabiliser davantage le gradient thermique lors de la solidification, d'éviter le refroidissement excessif du côté du moule opposé au premier écran thermique, et d'améliorer ainsi significativement la qualité des pièces obtenues.

Dans un exemple de réalisation, l'installation comprend en outre un troisième écran thermique fixe par rapport à l'enceinte, distinct des premier et deuxième écrans thermiques, ledit troisième écran thermique étant présent dans la zone de chauffage et étant superposé au premier écran thermique le long de l'axe de l'enceinte.

Une telle caractéristique est avantageuse afin de limiter les pertes radiatives vers la partie inférieure de l'enceinte.

L'installation comprend en outre :
- un quatrième écran thermique mobile par rapport au moule et distinct des premier et deuxième écrans thermiques et éventuellement du troisième écran thermique lorsque ce dernier est présent, le quatrième écran thermique étant situé du deuxième côté du moule et étant superposé au deuxième écran thermique le long de l'axe de l'enceinte, la largeur du quatrième écran thermique étant inférieure à la largeur du deuxième écran thermique, et
- un troisième système de déplacement, distinct des premier et deuxième systèmes de déplacement, configuré pour déplacer le quatrième écran thermique le long de l'axe de l'enceinte indépendamment du deuxième écran thermique.

Le « quatrième écran thermique » sera appelé dans la suite indifféremment « quatrième écran thermique » ou « écran thermique additionnel ».

Une telle caractéristique est avantageuse lorsque le ou les moules utilisés présentent une forme ou des dimensions laissant un espace insuffisant pour que le deuxième écran thermique suive le front de solidification sur toute la durée de la solidification. Ainsi selon cet exemple de réalisation, le deuxième écran thermique suivra le front de solidification durant une première phase de la solidification dirigée et sera positionné en regard de ce front durant cette phase. Une fois que le deuxième écran thermique ne pourra plus continuer de suivre le front de solidification du fait d'un espace insuffisant délimité par le ou les moules, le déplacement du deuxième écran thermique sera stoppé. Le déplacement du quatrième écran thermique sera alors initié à l'aide du troisième système de déplacement afin que le quatrième écran thermique, moins large que le deuxième écran thermique, continue de suivre le front de solidification de sorte à être positionné en regard de ce dernier. Une telle caractéristique permet donc d'assurer une stabilité du gradient thermique tout au long de la solidification dirigée même lorsque la géométrie des moules est telle que le deuxième écran thermique ne puisse suivre le front de solidification durant tout le procédé.

Dans un exemple de réalisation, l'installation comprend une pluralité de moules destinés à recevoir le matériau en fusion et présents dans la zone de chauffage, lesdits moules étant présents autour du deuxième écran thermique, l'installation comprenant en outre un système de chauffage configuré pour chauffer la zone de chauffage, le système de chauffage et le premier écran thermique étant présents autour desdits moules.

La présente invention vise également un procédé de fabrication d'au moins une pièce par mise en oeuvre d'un procédé Bridgman et de l'installation telle que décrite plus haut, le procédé comprenant au moins :
- l'introduction d'un matériau en fusion dans ledit au moins un moule,
- la solidification dirigée du matériau en fusion en déplaçant ledit au moins un moule comprenant le matériau en fusion depuis la zone de chauffage vers la zone de refroidissement le long de l'axe de l'enceinte par actionnement du premier système de déplacement, et
- le déplacement du deuxième écran thermique le long de l'axe de l'enceinte par actionnement du deuxième système de déplacement afin de positionner le deuxième écran thermique en face du front de solidification du matériau en fusion durant tout ou partie de la solidification dirigée.

Dans un exemple de réalisation, le deuxième écran thermique est déplacé en le positionnant en face du front de solidification durant une première phase de la solidification dirigée, puis le quatrième écran thermique est déplacé le long de l'axe de l'enceinte par actionnement du troisième système de déplacement afin de positionner le quatrième écran thermique en face du front de solidification du matériau en fusion durant une deuxième phase de la solidification dirigée.

Dans un exemple de réalisation, la pièce peut être une pièce de turbomachine. En particulier, la pièce peut être une aube de turbomachine, un distributeur ou un secteur d'anneau. Dans un exemple de réalisation, la pièce fabriquée est une pièce de turbomachine aéronautique. En variante, il s'agit d'une pièce de turbine terrestre.

Dans un exemple de réalisation, le matériau en fusion est un matériau métallique. En variante, le matériau en fusion est un matériau céramique, par exemple un matériau céramique de composition eutectique.

Le matériau céramique formant le matériau en fusion peut par exemple comporter au moins : de l'alumine Al₂O₃, de la zircone ZrO₂, un oxyde de terre rare, un grenat d'aluminium et de terre rare RE₃Al₅O₁₂ ou une pérovskite REAlO₃, où RE désigne un élément terre rare. L'oxyde de terre rare peut avoir pour formule chimique RE₂O₃ avec RE tel que défini ci-avant et peut par exemple être Y₂O₃ ou La₂O₃. Le matériau céramique peut, par exemple, comporter de l'alumine et de la zircone. Le matériau céramique peut être de composition eutectique et peut par exemple être choisi parmi les mélanges suivants : Al₂O₃-ZrO₂, Al₂O₃-YAG (YAG correspondant à Y₃AlₛO₁₂), RE₃Al₅O₁₂-Al₂O₃ où RE est un élément terre rare, Al₂O₃-RE₃Al₅O₁₂-ZrO₂ et Al₂O₃YAG-ZrO₂.

En variante, le matériau en fusion peut être un matériau métallique, et par exemple être un superalliage comme un superalliage de nickel.

### Brève description des dessins

D'autres caractéristiques et avantages de l'invention ressortiront de la description suivante, donnée à titre non limitatif, en référence aux dessins annexés, sur lesquels :
- les figures 1 et 2 sont des résultats de simulations numériques reproduits de manière schématique montrant l'aspect des isothermes au niveau du front de solidification à différents instants de la mise en oeuvre d'un procédé Bridgman réalisé à l'aide d'une installation hors invention,
- la figure 3 illustre de manière schématique et partielle un premier exemple d'installation selon l'invention,
- la figure 4 illustre de manière schématique et partielle un deuxième exemple d'installation selon l'invention,
- les figures 5A à 5D illustrent de manière schématique une manière de positionner le deuxième écran thermique sur le deuxième système de déplacement,
- la figure 6 illustre de manière schématique et partielle un troisième exemple d'installation selon l'invention, et
- les figures 7A et 7B illustrent de manière schématique et partielle un quatrième exemple d'installation selon l'invention.

### Description détaillée de modes de réalisation

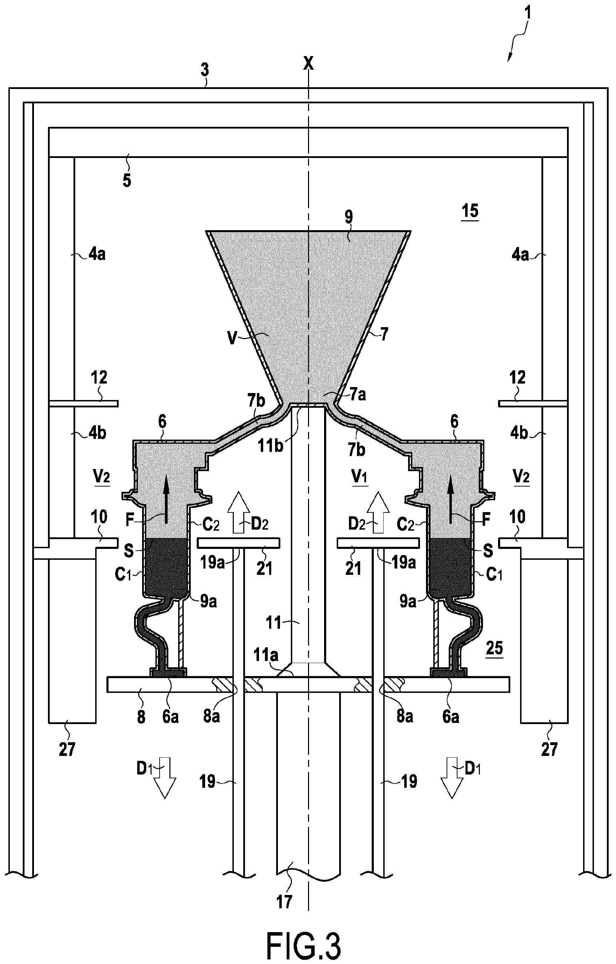

La figure 3 illustre un premier exemple d'installation 1 selon l'invention. L'installation 1 constitue un four pour la fabrication d'une pièce par mise en oeuvre d'un procédé Bridgman. La pièce obtenue peut être en matériau réfractaire, par exemple métallique ou en matériau céramique, par exemple en matériau céramique de composition eutectique. La pièce obtenue peut présenter une microstructure cristalline. La pièce obtenue peut par exemple être une pièce de turbomachine, comme une aube de turbomachine. Dans les exemples d'installation illustrés, les moules 6 ont chacun une forme permettant la fabrication d'une aube de turbomachine.

L'installation 1 comprend une enceinte 3 définissant un volume intérieur dans lequel le procédé Bridgman est destiné à être réalisé. L'enceinte 3 est fixe durant la solidification dirigée. Un réservoir 7 définissant un volume V contenant du matériau 9 en fusion est présent à l'intérieur de l'enceinte 3. Le réservoir 7 présente un fond 7a qui est en communication avec une pluralité de canaux 7b qui débouchent chacun dans un moule distinct 6. Ainsi, le matériau en fusion 9 traverse les canaux 7b sous l'effet de la gravité pour être transféré jusqu'aux moules 6 et remplir ces derniers. Les moules 6 présentent chacun la forme de la pièce à obtenir. Au sein d'une même installation, les moules 6 peuvent être identiques ou peuvent en variante être différents en termes de forme et/ou de dimensions. L'exemple d'installation 1 illustré comprend une pluralité de moules 6 mais on ne sort pas du cadre de l'invention lorsque cette installation ne comprend qu'un seul moule.

Les moules 6 sont présents dans une zone de chauffage 15 située dans la partie supérieure du volume intérieur défini par l'enceinte 3. Dans l'exemple illustré, les moules 6 sont positionnés de manière circonférentielle autour de l'axe X de l'enceinte 3. Un système de chauffage 4a et 4b est présent à l'intérieur de l'enceinte 3 et est configuré pour chauffer la zone de chauffage 15 afin de faire fondre le matériau. Le système de chauffage peut comporter un premier 4a et un deuxième 4b suscepteurs ainsi qu'un inducteur (non représenté). Lorsque l'inducteur est parcouru par un courant, l'inducteur créé un champ électromagnétique qui induit dans les suscepteurs 4a et 4b un courant provoquant réchauffement de ces derniers. Chacun des suscepteurs 4a et 4b délimite latéralement la zone de chauffage 15. Le premier suscepteur 4a est superposé au deuxième suscepteur 4b le long de l'axe de l'enceinte X. Les suscepteurs 4a et 4b sont dans l'exemple illustré séparés par un écran thermique 12. L'écran thermique 12 (troisième écran thermique) est fixe par rapport à l'enceinte 3 et reste donc à la même position durant la solidification dirigée. La partie supérieure de la zone de chauffage 15 est fermée par une paroi supérieure 5.

L'installation 1 comprend en outre une zone de refroidissement 25 qui est séparée de la zone de chauffage 15 par le premier écran thermique 10. Le premier écran thermique 10 est fixe par rapport à l'enceinte 3 et reste donc à la même position durant la solidification dirigée. Le troisième écran thermique 12 est superposé au premier écran thermique 10 le long de l'axe X de l'enceinte. Le troisième écran thermique 12 est situé au-dessus des moules 6. Une partie au moins du moule est présente dans l'enceinte 3 à une hauteur comprise entre la hauteur à laquelle est présent le premier écran thermique 10 et la hauteur à laquelle est présent le troisième écran thermique 12. Ces hauteurs sont mesurées le long de l'axe X de l'enceinte 3. La présence du troisième écran thermique 12 est toutefois optionnelle. La zone de refroidissement 25 est située dans la partie inférieure du volume intérieur défini par l'enceinte 3. La zone de chauffage 15 est superposée à la zone de refroidissement 25 le long de l'axe de l'enceinte X. La zone de refroidissement 25 comprend un système de refroidissement 27 dans lequel circule un fluide de refroidissement. Le système 27 permet de refroidir la zone de refroidissement 25 et de maintenir sa température à une valeur permettant la solidification du matériau en fusion 9. Le système de refroidissement 27 peut comme illustré entourer la zone de refroidissement 25. Le système de refroidissement 27 délimite latéralement la zone de refroidissement 25. Le système de refroidissement 27 est situé en dessous du premier écran thermique 10. Le premier écran thermique 10 est situé entre le système de chauffage 4a et 4b et le système de refroidissement 27.

Chacun des moules 6 est relié à un premier système de déplacement configuré pour déplacer les moules 6 depuis la zone de chauffage 15 vers la zone de refroidissement 25. Plus précisément, chaque moule 6 présente une extrémité inférieure 6a solidaire d'un support mobile 8. Le support mobile 8 est dans l'exemple illustré sous la forme d'un plateau mais on ne sort pas du cadre de l'invention lorsque le support 8 présente une forme non plane. Le premier système de déplacement comprend un premier vérin 17 configuré pour abaisser le support 8 et donc les moules 6 dans la direction D1 qui est parallèle à l'axe X. Le déplacement des moules 6 dans la direction D1 permet de refroidir le matériau en fusion 9 et de réaliser sa solidification dirigée afin d'obtenir la pièce par mise en oeuvre du procédé Bridgman.

On a représenté à la figure 3 une configuration de l'installation 1 en cours de mise en oeuvre du procédé Bridgman où l'on voit que chacun des moules 6 contient une première partie solidifiée 9a située du côté de la zone de refroidissement 25 et une deuxième partie fondue 9 située du côté opposé à cette zone 25. Le front de solidification S sépare la partie solidifiée 9a de la zone fondue 9 et se déplace le long de la direction F durant le procédé.

L'installation 1 comprend en outre dans l'exemple illustré un élément de support additionnel 11 s'étendant le long de la l'axe X. L'élément 11 comprend une extrémité inférieure 11a solidaire du support mobile 8 et une extrémité supérieure 11b solidaire du réservoir 7. L'élément 11 permet avantageusement de renforcer l'ensemble constitué par les moules 6 et le réservoir 7. La présence de cet élément 11 est toutefois optionnelle. Lorsque le support mobile 8 est abaissé dans la direction D1, l'ensemble constitué par les moules 6, les canaux 7b, le réservoir 7 et l'élément additionnel 11, lorsqu'il est présent, est déplacé en bloc vers la zone de refroidissement 27.

Dans l'exemple illustré, le premier écran thermique 10 est fixe et entoure les moules 6. Le premier écran thermique 10 présente une forme annulaire. Le système de chauffage 4a et 4b entoure lui aussi dans l'exemple illustré les moules 6. Ainsi, dans cet exemple, les moules 6 présentent chacun un côté externe C₁ présent en regard du premier écran thermique 10 et un côté interne C₂ situé du côté opposé au premier écran thermique 10. Le côté interne C₂ est situé du côté du volume interne V1 de la zone de chauffage 15 entouré par les moules 6. Le côté interne C₂ est situé du côté du centre de la zone de chauffage. Le côté externe C₁ est situé du côté du volume externe V2 de la zone de chauffage 15 entourant les moules 6. Le côté externe C₁ est situé du côté de la périphérie de la zone de chauffage 15. Les côtés externes C₁ et interne C₂ correspondent, pour chaque moule, à deux côtés diamétralement opposés de ce moule.

L'installation 1 illustrée à la figure 3 comprend en outre un deuxième écran thermique 21 de forme annulaire. Le deuxième écran thermique 21 est présent autour de l'élément de renfort 11 (et de l'axe X). Ce deuxième écran thermique 21 est présent en regard du côté interne C₂ de chacun des moules 6. Le deuxième écran thermique 21 est mobile par rapport aux moules 6 et est destiné à être déplacé dans l'enceinte 3 le long de l'axe X durant le procédé Bridgman de sorte à être positionné en regard du front de solidification S (à la même hauteur que ce dernier). Le fait de positionner le deuxième écran thermique 21 en regard du front de solidification S durant la solidification dirigée permet avantageusement de réduire, voire de supprimer, le gradient thermique horizontal et d'obtenir une pièce ayant une qualité et des propriétés améliorées.

Afin de permettre le déplacement du deuxième écran thermique 21, l'installation 1 comprend un deuxième système de déplacement qui comprend une pluralité de vérins 19. Chacun de ces vérins 19 est relié à son extrémité 19a au deuxième écran thermique 21 de sorte à permettre le déplacement de ce dernier le long de l'axe X. Chacun des vérins 19 présente à son extrémité 19a un système de support sur lequel est posé le deuxième écran thermique 21. Un exemple de système support sera décrit dans la suite. Les vérins 19 du deuxième système de déplacement s'étendent le long de l'axe X au travers d'orifices 8a ménagés dans le support mobile 8. Les vérins 19 sont positionnés de manière circonférentielle autour de l'axe X. Dans la configuration illustrée à la figure 3, on a représenté un mouvement vers le haut (direction D2) du deuxième écran thermique 21 suite à l'actionnement des vérins 19 mais plus généralement le deuxième écran thermique 21 peut être amené à être déplacé vers le haut ou vers le bas selon la position du front de solidification durant le procédé Bridgman. Les matériaux constituant les écrans thermiques fixes ou mobiles mis en oeuvre sont connus en soi. Les écrans thermiques peuvent par exemple être en carbone ou en feutre de carbone.

La mise en oeuvre d'un procédé Bridgman à l'aide de l'installation de la figure 3 va à présent être brièvement décrite. Le système de chauffage 4a et 4b est actionné afin de faire fondre le matériau présent dans le réservoir 7. Le matériau fondu 9 s'écoule alors sous l'effet de la gravité afin de remplir les moules 6. Le premier système de déplacement 17 est ensuite actionné afin d'abaisser le support mobile 8 et les moules 6. La solidification dirigée du matériau en fusion 9 est ainsi réalisée du fait du rapprochement du matériau fondu 9 de la zone de refroidissement 25. Durant le procédé, l'intérieur de l'enceinte 3 est maintenu sous vide. Lors de cette solidification, le front de solidification S se déplace le long de la direction matérialisée par la flèche F. Durant la solidification dirigée, le deuxième écran thermique 21 est déplacé de sorte à être positionné à la même hauteur que le front de solidification S afin de stabiliser le gradient thermique au niveau du front S. Le signal provenant d'un dispositif de détection ou d'estimation de la position du front de solidification est transmis à un module de commande afin d'actionner le deuxième système de déplacement et faire varier la position du deuxième écran thermique. La position du front de solidification peut être détectée à partir de la mesure de température effectuée par des thermocouples positionnés au voisinage de chacun des moules. En variante, la position du front de solidification peut être estimée par simulation numérique durant la solidification.

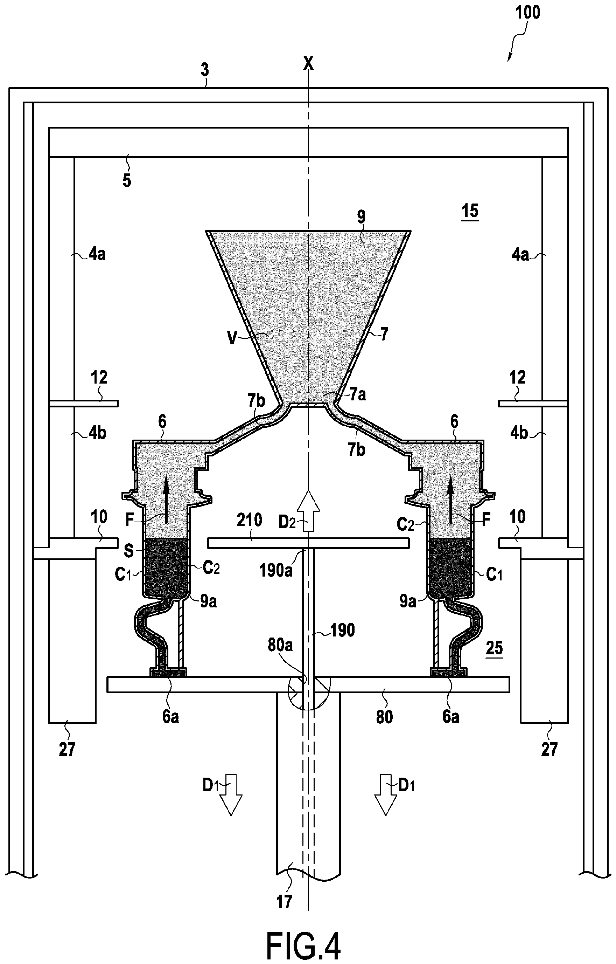

On a représenté à la figure 4 une variante d'installation 100 qui diffère de celle de la figure 3 en ce que le deuxième écran thermique 210 n'est plus de forme annulaire mais sous la forme d'un disque. De la même manière que décrit plus haut, un vérin 190 du deuxième système de déplacement traverse le support mobile 80 au travers de l'orifice 80a. Dans l'exemple illustré, le vérin 190 traverse le support mobile 80 au niveau du centre de ce dernier. Le vérin 190 est configuré pour coulisser à l'intérieur du vérin 17 assurant la mise en mouvement des moules 6 vers la zone de refroidissement 25. Les vérins 17 et 190 s'étendent selon le même axe, correspondant dans l'exemple illustré à l'axe X. Le deuxième écran thermique 210 est posé sur le vérin au niveau de son extrémité 190a. Le vérin 190 permet de déplacer le deuxième écran thermique 210 dans la direction D2 afin de positionner ce deuxième écran thermique en regard du front de solidification S durant la solidification dirigée. On notera aussi que l'exemple d'installation 100 de la figure 4 ne met pas en oeuvre d'élément de renfort additionnel.

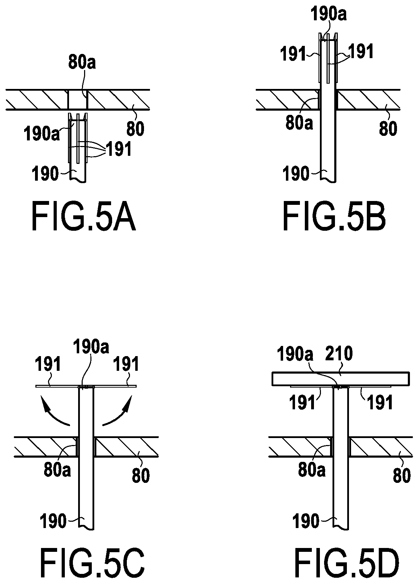

Les figures 5A à 5D illustrent le positionnement du deuxième écran thermique 210 sur le deuxième système de déplacement dans le cas de l'installation 100 de la figure 4 étant entendu qu'une méthode similaire peut être utilisée avec les vérins 19 de l'installation 1 de la figure 3.

Le vérin 190 est tout d'abord introduit au niveau de l'orifice 80a de sorte à traverser le support mobile 80 (figures 5A et 5B). Le vérin 190 comprend une pluralité de tiges déployables 191 au niveau de son extrémité 190a. Les tiges déployables 191 sont initialement rétractées afin de permettre l'introduction du vérin 190 au travers du support mobile 80. Après introduction du vérin 190 au travers du support mobile 80, les tiges 191 sont alors déployées afin de former un support s'étendant transversalement, par exemple perpendiculairement, par rapport à l'axe du vérin 190 (figure 5C). Le deuxième écran thermique 210 est alors posé sur le support présent au niveau de l'extrémité 190a du vérin 190 (figure 5D).

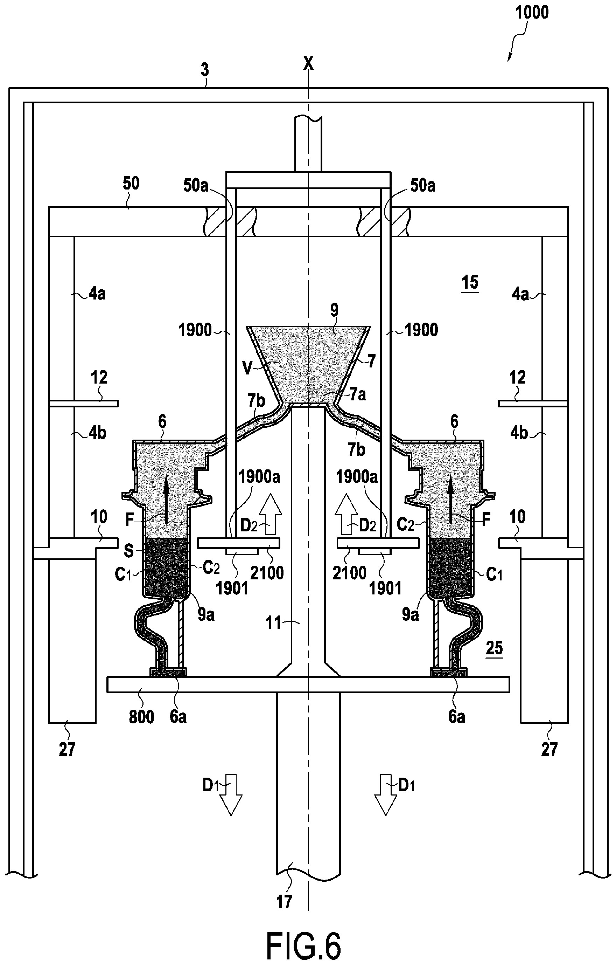

On a représenté à la figure 6 une autre variante d'installation 1000. Cette installation 1000 est similaire à l'installation 1 de la figure 3 à la différence que les vérins 1900 du deuxième système de déplacement traversent la paroi supérieure 50 au niveau d'une pluralité d'orifices 50a et non plus le support mobile 800. Le deuxième écran thermique 2100 est de forme annulaire et repose sur des cales 1901 solidaires de chaque vérin 1900 au niveau des extrémités 1900a. Les cales 1901 s'étendent transversalement, par exemple perpendiculairement, par rapport aux vérins 1900 afin d'assurer le maintien du deuxième écran thermique 2100.

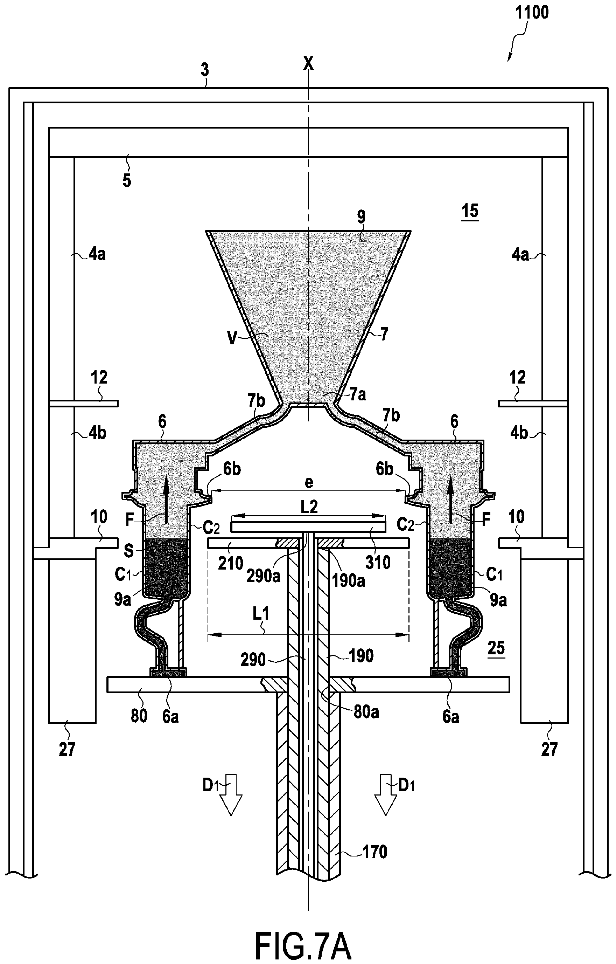

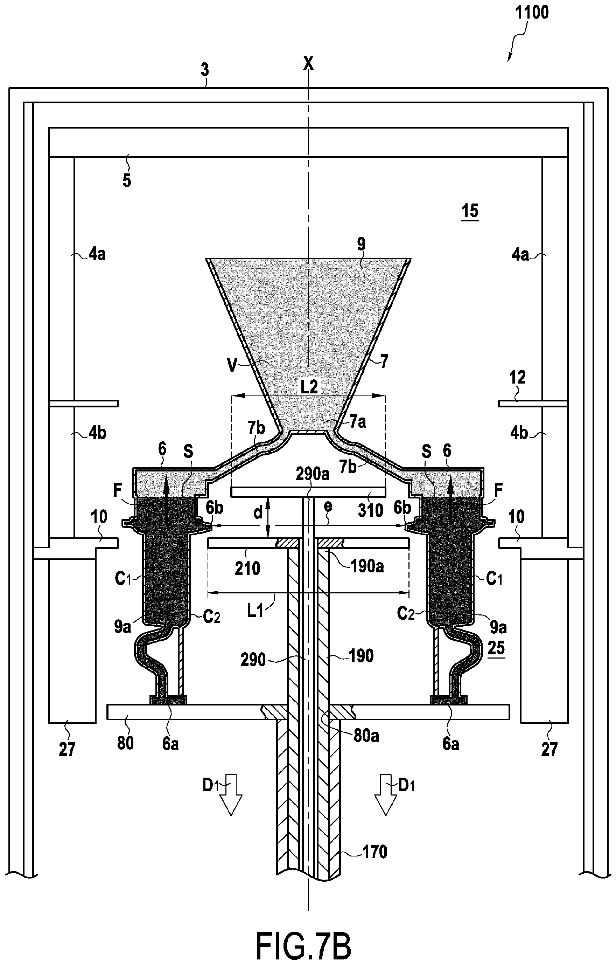

On a représenté aux figures 7A et 7B une variante d'installation 1100 qui comprend, en plus du deuxième écran thermique mobile 210, un quatrième écran thermique mobile 310 par rapport aux moules 6. Le quatrième écran thermique 310 est situé du côté interne C2 de chacun des moules 6. Le quatrième écran thermique 310 est superposé au deuxième écran thermique 210 le long de l'axe de l'enceinte X. De la même manière que décrit plus haut, le premier système de déplacement comprend un vérin 170 configuré pour abaisser le support mobile 80 et les moules 6 dans le four afin de réaliser la solidification du matériau en fusion 9. Le deuxième système de déplacement comprend, dans l'exemple illustré, un vérin 190 à l'extrémité 190a duquel le deuxième écran thermique 210 est présent. Le vérin 190 est configuré pour coulisser à l'intérieur du vérin 170. Les vérins 170 et 190 s'étendent selon le même axe, correspondant dans l'exemple illustré à l'axe X. L'installation 1100 comprend en outre un troisième système de déplacement qui comprend un vérin 290 à l'extrémité 290a duquel le quatrième écran thermique 310 est présent. Le deuxième vérin 290 est configuré pour coulisser à l'intérieur du premier vérin 190. Les vérins 190 et 290 s'étendent selon le même axe, correspondant dans l'exemple illustré à l'axe X. La largeur L2 du quatrième écran thermique 310 est inférieure à la largeur L1 du deuxième écran thermique 210. Une telle installation 1100 est avantageuse lorsque les moules 6 utilisés présentent une forme ou des dimensions laissant un espace insuffisant pour que le deuxième écran thermique 210 suive le front de solidification sur toute la durée de la solidification. En effet, on voit à la figure 7A que l'espacement e entre les moules 6 au niveau des points 6b est inférieur à la largeur L1. De la sorte, le deuxième écran thermique 210 ne pourra pas monter à une position plus haute que celle des points 6b des moules 6. Ainsi, selon cet exemple de réalisation, le deuxième écran thermique 210 suivra le front de solidification durant une première phase de la solidification dirigée et sera positionné en regard de ce front durant cette première phase. Une fois que le deuxième écran thermique ne pourra plus continuer de suivre le front de solidification du fait d'un espacement e insuffisant entre les moules 6, le déplacement du deuxième écran thermique 210 sera stoppé. Le déplacement du quatrième écran thermique 310 sera alors initié à l'aide du troisième système de déplacement afin que le quatrième écran thermique 310, moins large que le deuxième écran thermique, continue de suivre le front de solidification de sorte à être positionné en regard de ce dernier (voir figure 7B et espacement d non nul entre les deux écrans thermiques 210 et 310). Le deuxième écran thermique 210 peut être maintenu fixe pendant le déplacement du quatrième écran thermique 310. Le quatrième écran thermique 310 présente en effet une largeur L2 inférieure à l'espacement e et peut donc continuer de suivre le front de solidification au-delà des points 6b (voir figure 7B).

Dans une variante non illustrée, on pourrait utiliser des deuxième 210 et quatrième 310 écrans thermiques de forme annulaire.

## Revendications

1. Installation (1100) pour la fabrication d'une pièce par mise en oeuvre d'un procédé Bridgman, ladite installation comprenant :
- au moins un moule (6) destiné à recevoir un matériau en fusion (9), le moule (6) étant présent dans une zone de chauffage (15) située à l'intérieur d'une enceinte (3),
- une zone de refroidissement (25) située à l'intérieur de l'enceinte (3) et séparée de la zone de chauffage (15) par un premier écran thermique (10), le premier écran thermique (10) étant fixe par rapport à l'enceinte (3) et étant situé d'un premier côté (C₁) du moule, la zone de chauffage (15) étant superposée à la zone de refroidissement (25) le long d'un axe (X) de l'enceinte (3),
- un premier système de déplacement (170) configuré pour déplacer le moule (6) dans l'enceinte (3) depuis la zone de chauffage (15) vers la zone de refroidissement (25) le long de l'axe (X) de l'enceinte (3),
- un deuxième écran thermique mobile (210) par rapport au moule (6), distinct du premier écran thermique (10) et situé d'un deuxième côté (C₂) du moule (6) opposé au premier côté (C₁),
- un deuxième système de déplacement (190), distinct du premier système de déplacement (170), configuré pour déplacer le deuxième écran thermique (210) dans l'enceinte (3) le long de l'axe (X) de l'enceinte (3),
- un écran thermique additionnel mobile (310) par rapport au moule et distinct des premier et deuxième écrans thermiques, l'écran thermique additionnel étant situé du deuxième côté du moule et étant superposé au deuxième écran thermique le long de l'axe de l'enceinte, la largeur (L2) de l'écran thermique additionnel étant inférieure à la largeur (L1) du deuxième écran thermique, et
- un troisième système de déplacement (290), distinct des premier et deuxième systèmes de déplacement, configuré pour déplacer l'écran thermique additionnel dans l'enceinte le long de l'axe de l'enceinte indépendamment du deuxième écran thermique.

2. Installation (1100) selon la revendication 1, comprenant en outre un troisième écran thermique fixe (12) par rapport à l'enceinte (3), distinct des premier (10) et deuxième (210) écrans thermiques et de l'écran thermique additionnel (310), ledit troisième écran thermique (12) étant présent dans la zone de chauffage (15) et étant superposé au premier écran thermique (10) le long de l'axe (X) de l'enceinte (3).

3. Installation (1100) selon l'une quelconque des revendications 1 ou 2, comprenant une pluralité de moules (6) destinés à recevoir le matériau en fusion (9) et présents dans la zone de chauffage (15), lesdits moules (6) étant présents autour du deuxième écran thermique (210), l'installation comprenant en outre un système de chauffage (4a ; 4b) configuré pour chauffer la zone de chauffage (15), le système de chauffage (4a ; 4b) et le premier écran thermique (10) étant présents autour desdits moules (6).

4. Procédé de fabrication d'au moins une pièce par mise en oeuvre d'un procédé Bridgman et de l'installation (1100) selon l'une quelconque des revendications 1 à 3, le procédé comprenant au moins :
- l'introduction d'un matériau en fusion (9) dans ledit au moins un moule (6),
- la solidification dirigée du matériau en fusion (9) en déplaçant ledit au moins un moule (6) comprenant le matériau en fusion (9) depuis la zone de chauffage (15) vers la zone de refroidissement (25) le long de l'axe (X) de l'enceinte (3) par actionnement du premier système de déplacement (170), et
- le déplacement du deuxième écran thermique (210) le long de l'axe (X) de l'enceinte (3) par actionnement du deuxième système de déplacement (190) afin de positionner le deuxième écran thermique (210) en face du front de solidification (S) du matériau en fusion (9) durant une première phase de la solidification dirigée, puis l'écran thermique additionnel (310) étant déplacé le long de l'axe de l'enceinte par actionnement du troisième système de déplacement (290) afin de positionner l'écran thermique additionnel (310) en face du front de solidification du matériau en fusion durant une deuxième phase de la solidification dirigée.

5. Procédé selon la revendication 4, dans lequel la pièce est une pièce de turbomachine.

6. Procédé selon la revendication 5, dans lequel la pièce est une aube de turbomachine.

7. Procédé selon l'une quelconque des revendications 4 à 6, dans lequel le matériau en fusion (9) est un matériau métallique ou un matériau céramique.

## Patentansprüche

1. Anlage (1100) für die Herstellung eines Teils durch Umsetzung eines Bridgman-Verfahrens, wobei die Anlage umfasst:
- mindestens eine Form (6) zur Aufnahme eines geschmolzenen Materials (9), wobei sich die Form (6) in einer Heizzone (15) befindet, die innerhalb eines Gehäuses (3) angeordnet ist,
- eine Kühlzone (25), die innerhalb des Gehäuses (3) angeordnet ist und durch einen ersten Hitzeschild (10) von der Heizzone (15) getrennt ist, wobei der erste Hitzeschild (10) in Bezug auf das Gehäuse (3) fest ist und sich auf einer ersten Seite (C₁) der Form befindet, wobei die Heizzone (15) längs einer Achse (X) des Gehäuses (3) oberhalb der Kühlzone (25) liegt,
- ein erstes Verschiebesystem (170), das dazu ausgelegt ist, die Form (6) in dem Gehäuse (3) von der Heizzone (15) in die Kühlzone (25) entlang der Achse (X) des Gehäuses (3) zu verschieben,
- einen zweiten Hitzeschild (210), der in Bezug auf die Form (6) beweglich, von dem ersten Hitzeschild (10) getrennt und auf einer zweiten Seite (C₂) der Form (6) gegenüber der ersten Seite (C₁) angeordnet ist,
- ein zweites Verschiebesystem (190), das von dem ersten Verschiebesystem (170) getrennt und dazu ausgelegt ist, den zweiten Hitzeschild (210) innerhalb des Gehäuses (3) entlang der Achse (X) des Gehäuses (3) zu verschieben,
- einen zusätzlichen Hitzeschild (310), der in Bezug auf die Form beweglich und von dem ersten und zweiten Hitzeschild getrennt ist, wobei der zusätzliche Hitzeschild auf der zweiten Seite der Form angeordnet ist und längs der Achse des Gehäuses oberhalb des zweiten Hitzeschilds liegt, wobei die Breite (L2) des zusätzlichen Hitzeschilds kleiner als die Breite (L1) des zweiten Hitzeschilds ist, und
- ein drittes Verschiebesystem (290), das von dem ersten und zweiten Verschiebesystem getrennt und dazu ausgelegt ist, den zusätzlichen Hitzeschild in dem Gehäuse entlang der Achse des Gehäuses unabhängig von dem zweiten Hitzeschild zu verschieben.

2. Anlage (1100) nach Anspruch 1, ferner umfassend einen dritten Hitzeschild (12), der in Bezug auf das Gehäuse (3) fest und von dem ersten (10), dem zweiten (210) und dem zusätzlichen Hitzeschild (310) getrennt ist, wobei der dritte Hitzeschild (12) sich in der Heizzone (15) befindet und längs der Achse (X) des Gehäuses (3) oberhalb des ersten Hitzeschilds (10) liegt.

3. Anlage (1100) nach einem der Ansprüche 1 oder 2, umfassend eine Vielzahl von Formen (6) zur Aufnahme des geschmolzenen Materials (9), die sich in der Heizzone (15) befinden, wobei sich die Formen (6) um den zweiten Hitzeschild (210) herum befinden, wobei die Anlage ferner ein Heizsystem (4a; 4b) umfasst, das dazu ausgelegt ist, die Heizzone (15) zu erhitzen, wobei das Heizsystem (4a; 4b) und der erste Hitzeschild (10) sich um die Formen (6) herum befinden.

4. Verfahren zur Herstellung mindestens eines Teils durch Umsetzung eines Bridgman-Verfahrens und der Anlage (1100) nach einem der Ansprüche 1 bis 3, wobei das Verfahren mindestens umfasst:
- Einbringen eines geschmolzenen Materials (9) in die mindestens eine Form (6),
- gerichtetes Verfestigen des geschmolzenen Materials (9) durch Verschieben der mindestens einen Form (6), die das geschmolzene Material (9) umfasst, von der Heizzone (15) zur Kühlzone (25) entlang der Achse (X) des Gehäuses (3) durch Betätigen des ersten Verschiebesystems (170) und
- Verschieben des zweiten Hitzeschilds (210) entlang der Achse (X) des Gehäuses (3) durch Betätigen des zweiten Verschiebesystems (190), um den zweiten Hitzeschild (210) während einer ersten Phase der gerichteten Verfestigung gegenüber der Verfestigungsfront (S) des geschmolzenen Materials (9) zu positionieren, wobei anschließend der zusätzliche Hitzeschild (310) entlang der Achse des Gehäuses verschoben wird, indem das dritte Verschiebesystem (290) betätigt wird, um den zusätzlichen Hitzeschild (310) während einer zweiten Phase der gerichteten Verfestigung gegenüber der Verfestigungsfront des geschmolzenen Materials zu positionieren.

5. Verfahren nach Anspruch 4, wobei es sich bei dem Teil um ein Turbomaschinenteil handelt.

6. Verfahren nach Anspruch 5, wobei es sich bei dem Teil um eine Turbomaschinenschaufel handelt.

7. Verfahren nach einem der Ansprüche 4 bis 6, wobei es sich bei dem geschmolzenen Material (9) um ein metallisches Material oder ein keramisches Material handelt.

## Claims

1. An installation (1100) for manufacturing a part by implementation of a Bridgman method, said installation comprising:
- at least one mold (6) intended to receive a melted material (9), the mold (6) being present in a heating zone (15) situated inside an enclosure (3),
- a cooling zone (25) situated inside the enclosure (3) and separated from the heating zone (15) by a first thermal screen (10), the first thermal screen (10) being fixed with respect to the enclosure (3) and being situated on a first side (C₁) of the mold, the heating zone (15) being superimposed on the cooling zone (25) along an axis (X) of the enclosure (3),
- a first movement system (170) configured to move the mold (6) in the enclosure (3) from the heating zone (15) to the cooling zone (25) along the axis (X) of the enclosure (3),
- a second thermal screen (210) movable with respect to the mold (6), distinct from the first thermal screen (10) and situated on a second side (C₂) of the mold (6) opposite to the first side (C₁),
- a second movement system (190), distinct from the first movement system (170), configured to move the second thermal screen (210) in the enclosure (3) along the axis (X) of the enclosure (3),
- an additional thermal screen (310) movable with respect to the mold and distinct from the first and second thermal screens, the additional thermal screen being situated on the second side of the mold and being superimposed on the second thermal screen along the axis of the enclosure, the width (L2) of the additional thermal screen being less than the width (L1) of the second thermal screen, and
- a third movement system (290), distinct from the first and second movement systems, configured to move the additional thermal screen in the enclosure along the axis of the enclosure independently of the second thermal screen.

2. The installation (1100) according to claim 1, further comprising a third thermal screen (12) fixed with respect to the enclosure (3), distinct from the first (10) and second (210) thermal screens and from the additional thermal screen (310), said third thermal screen (12) being present in the heating zone (15) and being superimposed on the first thermal screen (10) along the axis (X) of the enclosure (3).

3. The installation (1100) according to any one of claims 1 or 2, comprising a plurality of molds (6) intended to receive the melted material (9) and present in the heating zone (15), said molds (6) being present around the second thermal screen (210), the installation further comprising a heating system (4a; 4b) configured to heat the heating zone (15), the heating system (4a; 4b) and the first thermal screen (10) being present around said molds (6).

4. A method for manufacturing at least one part by implementation of a Bridgman method and of the installation (1100) according to any one of claims 1 to 3, the method comprising at least:
- the introduction of a melted material (9) into said at least one mold (6),
- the directional solidification of the melted material (9) by moving said at least one mold (6) comprising the melted material (9) from the heating zone (15) toward the cooling zone (25) along the axis (X) of the enclosure (3) by activating the first movement system (170), and
- the movement of the second thermal screen (210) along the axis (X) of the enclosure (3) by activating the second movement system (190) so as to position the second thermal screen (210) in front of the solidification front (S) of the melted material (9) during a first phase of the directional solidification, then the additional thermal screen (310) being moved along the axis of the enclosure by actuation of the third movement system (290) so as to position the additional thermal screen (310) in front of the solidification front of the melted material during a second phase of the directional solidification.

5. The method according to claim 4, wherein the part is a turbomachine part.

6. The method according to claim 5, wherein the part is a turbomachine blade.

7. The method according to any one of claims 4 to 6, wherein the melted material (9) is a metal material or a ceramic material.
